# EUROPEAN PATENT APPLICATION

(11) **EP 4 205 862 A1**
(43) Date of publication of application: **05.07.2023**
(21) Application number: 22195547.9
(22) Date of filing: 14.09.2022
(51) Int. Cl.: B05B 7/00, B05B 12/00, C23C 4/00

(54) **PLASMA-BASED SUSPENSION COATING SYSTEM AND METHOD**

(30) Priority: 30.12.2021 KR 20210192862
(71) Applicant: Lee, Chang Hoon, Seoul 03477 (KR)
(72) Inventor: Lee, Chang Hoon, Seoul 03477 (KR)
(74) Representative: Studio Torta S.p.A.

(57) **Abstract**

A suspension coating system (100) using an atmospheric pressure plasma generator (110) includes a support (130) that fixedly supports a substrate (132), a plasma generator (110) that generates active species through plasma discharge, and includes a nozzle unit (112) of which at least a portion is disposed to face the substrate (132), and a suspension providing device (120) that transfers a suspension including nanoparticles (328) and a binder (327) to one side of the nozzle unit (112).

## Description

### TECHNICAL FIELD

The present disclosure relates to a plasma suspension coating system and method, and more particularly, to a suspension coating system using an atmospheric pressure plasma generator and method.

### BACKGROUND

Plasma is an ionized gas of electrons, neutral particles, or the like, and part of the plasma gas has high energy that can change the surface of materials. That is, the plasma may react directly with the surface of another material or react by elastic collision. A plasma generator mainly includes a tube configured to generate plasma when compressed air or nitrogen gas are collided with high-frequency, high-voltage electric charges.

In recent years, in place of low pressure or vacuum plasma, use of atmospheric pressure plasma devices has increased. The atmospheric pressure plasma device may be applied to various materials and substrates with low-temperature process, and since it does not require a vacuum container or a vacuum evacuation device, fast and economic treatment is provided. In addition, when used, a deposition method using the atmospheric pressure plasma provides good adhesion and low deposition temperature, and thus, it is used in relatively various industries by utilizing the advantages such as reduction in deformation or denaturation that accompanies high temperature heating in the related surface treatment process, semiconductor process, and display process.

Document KR 10-2020-0121452 A relates generally to suspension plasma spraying coating apparatus.

### SUMMARY

Embodiments disclosed herein provide a suspension coating system and method capable of coating nanoparticles on a substrate using an atmospheric pressure plasma generator.

A suspension coating system using an atmospheric pressure plasma generator is provided, which may include a support that fixedly supports a substrate, a plasma generator that generates active species through plasma discharge, and includes a nozzle unit of which at least a portion is disposed to face the substrate, and a suspension providing device that transfers a suspension including nanoparticles and a binder to one side of the nozzle unit.

The suspension may include nanoparticles and a binder, and in the nozzle unit, the nanoparticles may be ionized and deposited by plasma gas including active species and the binder may be vaporized.

The nanoparticles may include nanoparticles used in a spray deposition coating.

The suspension providing device may include a dispenser connected at one side to the nozzle unit and ejecting the suspension to one side of the nozzle unit, a passage part connected at one side to the dispenser and configured to move the suspension injected from the other side to the dispenser, and a containing part connected at one side to the passage part, in which the containing part may contain therein the suspension, and provide the suspension to the passage part using carrier gas injected from the other side.

The support part may be configured to fixedly support the substrate at one end, and adjust the distance between the nozzle unit and the substrate.

The suspension providing device may further include a speed measuring sensor configured to measure an ejection speed of the suspension, and a controller that controls a driving intensity of the plasma generator based on the ejection speed measured by the speed measuring sensor.

The suspension providing device may further include a thickness measuring sensor configured to measure a thickness of the nanoparticles deposited on the substrate, and a controller that controls whether or not to drive the plasma generator and the suspension providing device, based on the deposition thickness of the nanoparticles measured by the thickness measuring sensor.

A suspension coating method using an atmospheric pressure plasma generator according to another example is provided, which may include by a plasma generator including a nozzle unit, plasma-discharging a discharge gas to generate active species, by a suspension providing device, ejecting a suspension to one side of the nozzle unit, at the nozzle unit, ionizing nanoparticles by the active species and vaporizing a binder, and depositing and coating the ionized nanoparticles on a substrate.

The suspension coating method may further include adjusting a distance between the nozzle unit and the substrate by a support that fixedly supports the substrate from one side.

The suspension coating method may further include, by a speed measuring sensor, measuring an ejection speed of the suspension in the suspension providing device, by a thickness measuring sensor, measuring a deposition thickness of the nanoparticles deposited on the substrate, by a controller, controlling a driving intensity of the plasma generator based on the ejection speed measured by the speed measuring sensor, and by the controller, controlling whether or not to drive the plasma generator and the suspension providing device, based on the deposition thickness of the nanoparticles measured by the thickness measuring sensor.

According to various examples, as the nanoparticles in a suspension state is instantaneously exposed to ultra-high temperature plasma in the nozzle unit, it may change into ionized nanoparticles. Accordingly, by using the ionized nanoparticles for spray deposition coating, it is possible to form the deposition layer quickly and evenly on the substrate, and reduce the loss rate of nanoparticles deposited on the substrate, thereby increasing productivity and reducing costs.

In addition, according to various examples, since the distance between the nozzle unit and the substrate is adjustable, it is possible to easily deposit the nanoparticles on the substrate.

In addition, according to various examples, it is possible to easily deposit the nanoparticles using the plasma generator under atmospheric pressure.

In addition, according to various examples, it is possible to easily deposit the nanoparticles using the flame plasma generator.

In addition, according to various examples, since it is possible to check in real time whether or not the moving speed of the suspension including nanoparticles and binder falls to or below a reference value by using the speed measuring sensor, it is possible to reduce the deposition loss rate of the nanoparticles.

Further, according to various examples, it is possible to check in real time whether or not the coating thickness of the nanoparticles is equal to or greater than a reference value by using the thickness measuring sensor.

The effects of the present disclosure are not limited to the effects described above, and other effects that are not mentioned above can be clearly understood to those skilled in the art based on the description provided below.

### BRIEF DESCRIPTION OF THE DRAWINGS

The above and other objects, features and advantages of the present disclosure will become more apparent to those of ordinary skill in the art by describing in detail exemplary embodiments thereof with reference to the accompanying drawings, in which:
FIG. 1 schematically illustrates a suspension coating system using a plasma generator;
FIG. 2 schematically illustrates a suspension coating system using a plasma generator according to another example;
FIG. 3A is a front view schematically illustrating an atmospheric pressure plasma generator and a suspension providing device;
FIG. 3B is a front view schematically illustrating a flame plasma generator and a suspension providing device according to another example;
FIG. 4 is a flowchart illustrating a suspension coating method using an atmospheric pressure plasma generator; and
FIG. 5 is a flowchart illustrating a suspension coating method using an atmospheric pressure plasma generator according to another example.

### DETAILED DESCRIPTION

Hereinafter, example details for the practice of the present disclosure will be described in detail with reference to the accompanying drawings. However, in the following description, detailed descriptions of well-known functions or configurations will be omitted if it may make the subject matter of the present disclosure rather unclear.

In the accompanying drawings, the same or corresponding components are assigned the same reference numerals. In addition, in the following description of various examples, duplicate descriptions of the same or corresponding components may be omitted. However, even if descriptions of components are omitted, it is not intended that such components are not included in any example.

The terms used in the present disclosure will be briefly described prior to describing the disclosed embodiment(s) in detail. The terms used herein have been selected as general terms which are widely used at present in consideration of the functions of the present disclosure, and this may be altered according to the intent of an operator skilled in the art, related practice, or introduction of new technology. In addition, in specific cases, certain terms may be arbitrarily selected by the applicant, and the meaning of the terms will be described in detail in a corresponding description of the embodiment(s). Therefore, the terms used in the present disclosure should be defined based on the meaning of the terms and the overall content of the present disclosure rather than a simple name of each of the terms.

In the present disclosure, the singular forms "a," "an," and "the" are intended to include the plural forms as well, unless the context clearly indicates the singular forms. Further, the plural forms are intended to include the singular forms as well, unless the context clearly indicates the plural forms.

In the present disclosure, when a portion is stated as "comprising (including)" a component, unless specified to the contrary, it intends to mean that the portion may additionally comprise (or include or have) another component, rather than excluding the same.

In the present disclosure, it is to be noted that the upper direction of the drawing may be referred to as "upper portion" or "upper side" of the configuration shown in the drawing, and the lower direction may be referred to as "lower portion" or "lower side". In addition, in the drawings, a portion between the upper and lower portions of the configuration shown in the drawings, or a portion other than the upper and lower portions may be referred to as "side portion" or "side". Relative terms such as "upper portion" and "upper side" may be used to describe the relationship between components shown in the drawings, and the present disclosure is not limited by these terms.

In the present disclosure, a direction toward the inner space of a structure may be referred to as "inside", and a direction projecting into the open outer space may be referred to as "outside". Relative terms such as "inside" and "outside" may be used to describe the relationship between components shown in the drawings, and the present disclosure is not limited by these terms.

As used herein, the statement "A and/or B" means A, or B, or A and B.

Throughout the description, when a portion is stated as being connected to another portion, it intends to include not only an example in which the portions are directly connected, but also an example in which the portions are connected while having another component disposed therebetween.

Advantages and features of the disclosed examples and methods of accomplishing the same will be apparent by referring to examples described below in connection with the accompanying drawings. However, the present disclosure is not limited to the examples disclosed below, and may be implemented in various forms different from each other, and the examples are merely provided to make the present disclosure complete, and to fully disclose the scope of the disclosure to those skilled in the art to which the present disclosure pertains.

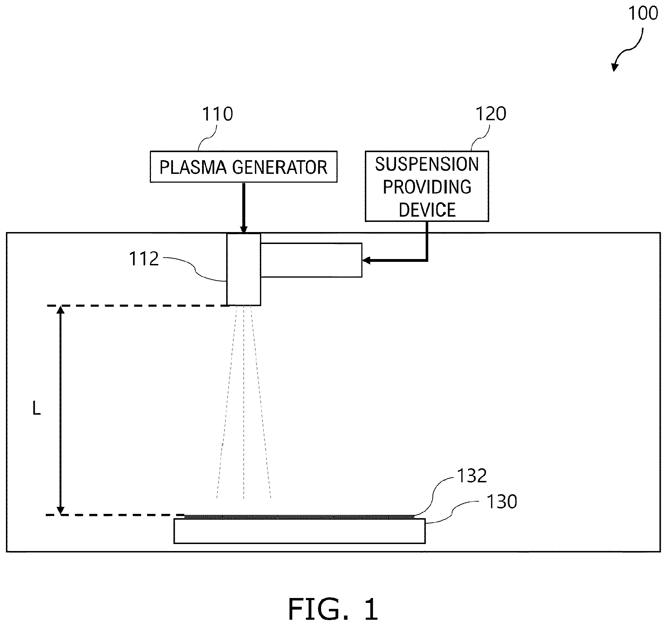

FIG. 1 schematically illustrates a suspension coating system 100 using a plasma generator 110.

As illustrated in FIG. 1, the suspension coating system 100 may include a plasma generator 110, a suspension providing device 120, and a support 130.

The plasma generator 110 may be a device for plasma-discharging a discharge gas to generate active species and discharging the plasma gas including the active species. The plasma generator 110 may be an atmospheric pressure plasma generator. The plasma generator 110 may include a nozzle unit 112. The nozzle unit 112 may include a discharge port through which the plasma gas and the suspension (or nanoparticles in a suspension state) are discharged. At least a portion of the nozzle unit 112 may be disposed to face a substrate 132. Accordingly, the plasma gas and the suspension discharged from the plasma generator 110 may be discharged toward the substrate 132.

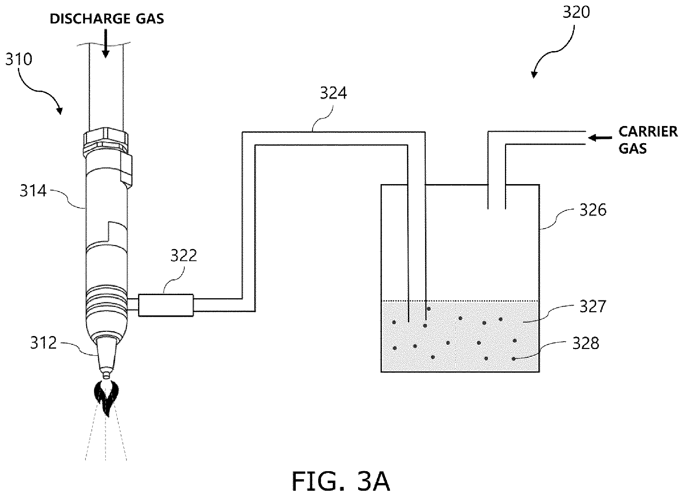

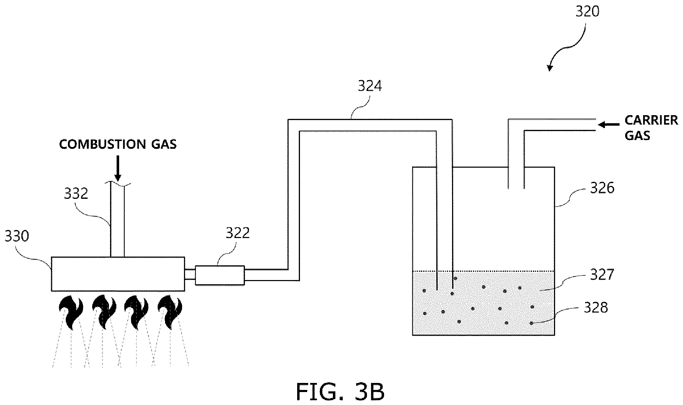

The suspension providing device 120 may be a device for transferring the suspension to one side of the nozzle unit 112 using a carrier gas. Specifically, one end of the suspension providing device 120 may be connected to the nozzle unit 112 to transfer, to the inside of the nozzle unit 112, a suspension including nanoparticles or nanopowder (hereinafter, collectively referred to as "nanoparticles") and a binder. The nanoparticles may correspond to a form of suspension aggregated in a binder including a liquid (e.g., water or alcohol), to be suitable for a spray coating deposition method. In general, the suspension refers to solid particles dispersed in a liquid, but is not limited thereto, and may represent liquid or solid particles dispersed in a gas, or particulates of a gas or other liquid dispersed in a liquid. In addition, the nanoparticles may be nanoparticles used in the spray coating deposition method. For example, the nanoparticles may correspond to carbon nanotube (CNT) or titanium (Ti) nanoparticles. The lower configuration of the suspension providing device 120 will be described in detail with reference to FIGS. 3A and 3B.

The nanoparticles transferred to the nozzle unit 112 may be ionized by the plasma gas including the active species generated by the plasma generator 110. Specifically, as the discharge gas introduced into one side of the nozzle unit 112 is plasma discharged, active species are generated and the nanoparticles introduced into the other side of the nozzle unit 112 may be ionized. The plasma generator 110 may be driven under atmospheric pressure.

As the plasma gas is discharged through the nozzle unit 112, nanoparticles may be deposited on the substrate 132. Accordingly, one surface of the substrate 132 may be coated with the nanoparticles by deposition coating. In this case, by using the nanoparticles for spray deposition coating, a deposition layer can be quickly and evenly formed on the substrate 132, and the loss rate of nanoparticles deposited on the substrate 132 can be reduced, thereby increasing productivity and reducing costs.

The support 130 may be disposed at a position for fixedly supporting the substrate 132. The substrate 132 may correspond to a space coated with the nanoparticles. The support 130 may be installed in a fixed position, or may be detachably provided on specific mounting equipment and the like.

The support 130 may be configured to be three-dimensionally movable to adjust a distance L, an angle, and the like between the nozzle unit 112 and the substrate 132. For example, the support 130 may adjust the distance L by using a robot arm (not illustrated), so that nanoparticles are easily deposited and coated on the substrate 132. In another example, the robot arm (not illustrated) may move the support 130 to any position.

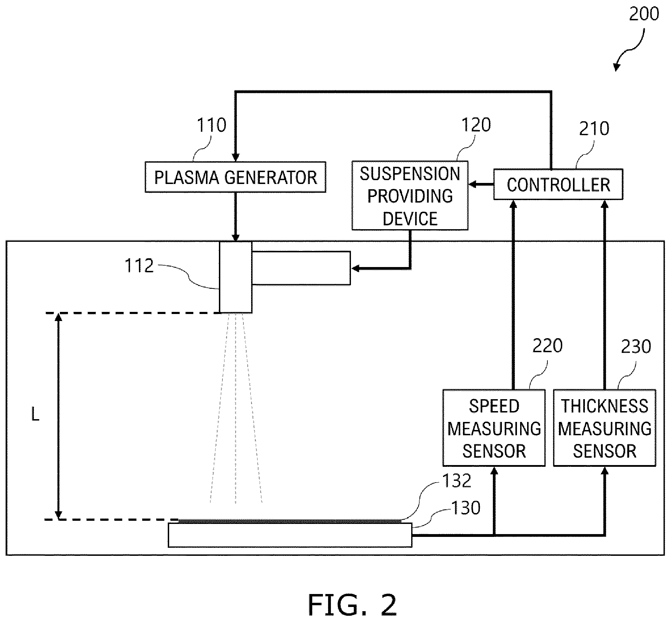

FIG. 2 schematically illustrates a suspension coating system 200 using the plasma generator 110 according to another example. Among the configurations illustrated in FIG. 2, descriptions of the configurations corresponding to those of FIG. 1 will be omitted.

As illustrated in FIG. 2, the suspension coating system 200 may include the plasma generator 110, the suspension providing device 120, the support 130, a controller 210, a speed measuring sensor 220, and a thickness measuring sensor 230. In the suspension coating system 200, the controller 210 receiving a signal from the speed measuring sensor 220 and/or the thickness measuring sensor 230 may control the plasma generator 110 and/or the suspension providing device 120, thereby adjusting the speed of the suspension including nanoparticles and binder moving from the nozzle unit 112 to the substrate 132 and the deposition thickness of the nanoparticles on the substrate 132. The controller 210 may correspond to a control unit including a microprocessor.

The speed measuring sensor 220 may be configured to measure the moving speed of the suspension including nanoparticles and binder moving from the nozzle unit 112 to the substrate 132 direction. For example, the speed measuring sensor 220 may include an electrical resistive type or electric capacitive type speed measuring sensor capable of outputting an electrical signal according to the moving speed of the suspension including nanoparticles and binder. In order to lower the deposition loss rate of the nanoparticles on the substrate 132, the speed measuring sensor 220 may be configured to check in real time whether or not the moving speed of the suspension including nanoparticles and binder falls to or below a reference value. The speed measuring sensor 220 may transmit the electrical signal determined according to the moving speed of the suspension including nanoparticles and binder to the controller 210.

The thickness measuring sensor 230 may be configured to measure a deposition thickness of the nanoparticles on the substrate 132. For example, the thickness measuring sensor 230 may include an optical sensor capable of changing electrical conductivity according to the deposition thickness of the nanoparticles and outputting an electrical signal, or an image sensor capable of capturing an image of a deposited film of the nanoparticles and measuring a thickness thereof, and/or an image signal processor, but is not limited thereto. The thickness measuring sensor 230 may be configured to check in real time whether or not a coating thickness of the nanoparticles deposited on the substrate 132 is equal to or greater than a reference value. The thickness measuring sensor 230 may transmit the electrical signal determined according to the thickness of the nanoparticles deposited on the substrate 132 to the controller 210.

The controller 210 may receive the electrical signal transmitted from the speed measuring sensor 220 and/or the thickness measuring sensor 230, and determine whether the moving speed of the suspension including nanoparticles and binder and/or the thickness of the nanoparticles deposited on the substrate 132 is equal to or greater than, or equal to or less than a reference value. According to the moving speed of the suspension or the deposition thickness of the nanoparticles determined as described above, the controller 210 may control whether or not to drive the plasma generator 110 and/or the suspension providing device 120, the driving time and intensity thereof, and the like. For example, if the controller 210 determines that the moving speed of the suspension is equal to or less than the reference value (e.g., sonic or subsonic) based on the electrical signal of the speed measuring sensor 220, the controller 210 may increase the driving intensity of the plasma generator 110. In addition, if the controller 210 determines that the deposition thickness of the nanoparticles on the substrate 132 is equal to or greater than the reference value based on the electrical signal of the thickness measuring sensor 230, the controller 210 may stop the operation of the plasma generator 110 and/or the suspension providing device 120. As described above, with the controller 210 controlling the operation of the plasma generator 110 and/or the suspension providing device 120, the loss rate of the nanoparticles applied on the substrate 132 by the deposition coating can be significantly reduced, and the suspension coating speed can be increased.

FIG. 3A is a front view schematically illustrating an atmospheric pressure plasma generator 310 and a suspension providing device 320.

The atmospheric pressure plasma generator 310 and the suspension providing device 320 illustrated in FIG. 3A may be used for the plasma generator 110 and the suspension providing device 120 of the suspension coating systems 100 and 200 illustrated in FIGS. 1 and 2.

The plasma generator 110 may be the atmospheric pressure plasma generator 310. The plasma generator 110 may include a generator, a high voltage transformer, electrodes for generating plasma discharge, and the like so as to be driven in a normal room temperature/atmospheric pressure environment. Specifically, the atmospheric pressure plasma generator 310 may include a nozzle unit 312 to discharge plasma, a gas supply pipe (not shown) with one side detachably attached with the nozzle unit 312 and the other side supplying a working gas (or discharge gas, plasma gas), and a body portion 314 detachably attached with a cable connected to a high voltage transformer (not shown) or the like.

The high frequency high voltage generated by the high voltage transformer may be applied to the electrodes installed inside the body portion 314, and a high frequency discharge in the form of an electric arc may be generated between the electrodes by the applied voltage. As described above, while the electric arc is generated inside the body portion 314, the working gas may contact the electric arc and be converted into the plasma state. For example, corona discharge may occur due to a high voltage applied between electrodes (e.g., Cu electrodes) installed inside the body portion 314. The working gas may collide with the electrons generated by the corona discharge and converted into a plasma state. The plasma beam generated in the body portion 314 may be discharged through an opening of the nozzle unit 312. For the working gas, one or more gases may be used singly or in combination according to the characteristics of the nanoparticles. For example, the working gas may be any one of nitrogen, argon, oxygen, hydrogen, helium, fluorine, or a combination thereof.

The suspension providing device 320 may include a dispenser 322 connected at one side to the nozzle unit and ejecting the suspension to one side of the nozzle unit, a passage part 324 connected at one side to the dispenser 322 and configured to move the suspension injected from the other side to the dispenser 322, and a containing part 326 connected at one side to the passage part 324, in which the containing part 326 contains the suspension therein and, using the carrier gas injected from the other side, provides the suspension to the passage part 324.

The dispenser 322 may be connected at one side to the nozzle unit 312 of the plasma generator 110 and eject the suspension including nanoparticles 328 and a binder 327 introduced from the passage part 324 to one side of the nozzle unit 312 as a spray type. If the suspension including the nanoparticles 328 and the binder 327 is ejected as the spray type, the binder included in the suspension may collide with plasma particles and electrons at a high temperature (e.g., 12,000K) or higher, and have an instantaneous increase in temperature and vaporize very quickly. The dispenser 322 may include a spray type dispenser, and may include a vibrating spray type dispenser using ultrasonic waves, for example. The nanoparticles 328 may be nanoparticles used in the spray coating deposition method. For example, the nanoparticles may correspond to carbon nanotubes or titanium nanoparticles.

The passage part 324 may be connected at one side to the dispenser 322, and configured to move the suspension injected from the other side by pressure with the carrier gas to the dispenser 322. The passage part 324 may have a tube or pipe shape.

The containing part 326 may contain therein the suspension including the nanoparticles 328 and the binder 327. According to the injection pressure of the carrier gas formed inside, the containing part 326 may move the suspension including the nanoparticles 328 and the binder 327 to the passage part 324. The carrier gas may include Ar and/or N₂.

FIG. 3B is a front view schematically illustrating a flame plasma generator 330 and the suspension providing device 320 according to another example.

The plasma generator 330 and the suspension providing device 320 illustrated in FIG. 3B may be used for the plasma generator 110 and the suspension providing device 120 of the suspension coating systems 100 and 200 illustrated in FIGS. 1 and 2.

In another example, the plasma generator 110 may be the flame plasma generator 330. The flame plasma generator 330 may be connected at one side to a combustion gas pipe 332, and include the combustion gas which may be LPG or LNG gas and compressed air mixed in a certain ratio, and generate a flame of a constant temperature with a flame burner of the flame plasma generator 330 to treat the surface. Specifically, the flame plasma generator 330 may include the dispenser 322 connected at one side to the suspension providing device 320, and ejecting the suspension to one side of the flame plasma generator 330, a passage part 324 connected at one side to the dispenser 322 and configured to move the suspension injected from the other side to the dispenser 322, and a containing part 326 connected at one side to the passage part 324, in which the containing part 326 contains the suspension therein and, using the carrier gas injected from the other side, provides the suspension to the passage part 324.

The dispenser 322 is connected at one side to the flame plasma generator 330, and ejects the suspension including the nanoparticles 328 and the binder 327 introduced from the passage part 324 into one side of the flame plasma generator 330 as a spray type. The dispenser 322 may include a spray type dispenser, and may include a vibrating spray type dispenser using ultrasonic waves, for example. The nanoparticles 328 may be nanoparticles used in the spray coating deposition method. For example, the nanoparticles may correspond to carbon nanotubes or titanium nanoparticles.

The passage part 324 may be connected at one side to the dispenser 322, and configured to move the suspension injected from the other side by pressure with the carrier gas to the dispenser 322. The passage part 324 may have a tube or pipe shape.

The containing part 326 may contain therein the suspension including the nanoparticles 328 and the binder 327. According to the injection pressure of the carrier gas formed inside, the containing part 326 may move the suspension including the nanoparticles 328 and the binder 327 to the passage part 324. The carrier gas may include Ar and/or N₂.

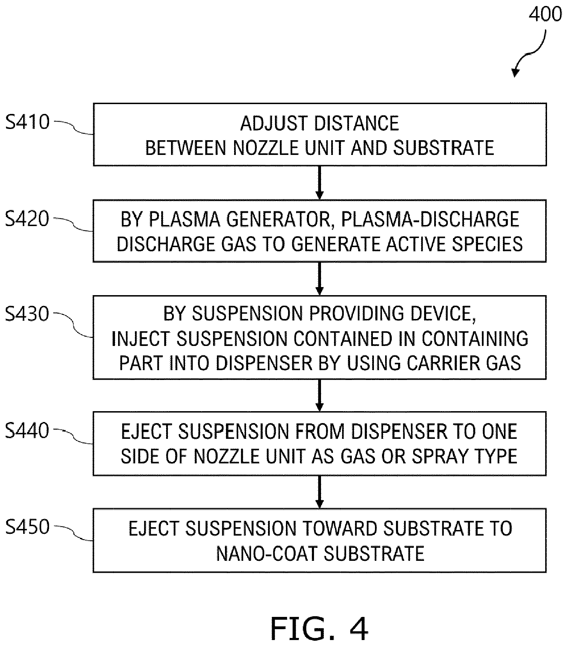

FIG. 4 is a flowchart illustrating a suspension coating method 400 using the atmospheric pressure plasma generator.

The suspension coating method 400 may be initiated by the support 130 adjusting the distance between the nozzle unit 112 and the substrate 132, at S410. Referring to FIG. 1, the support 130 may adjust a distance L between the nozzle unit 112 and the substrate 132. Specifically, the support 130 may be configured to adjust the distance L between the nozzle unit 112 and the substrate 132 such that nanoparticles are easily deposited on the substrate 132.

The discharge gas may be plasma-discharged by the plasma generator to generate active species, at S420. Referring to FIGS. 1 and 3B, the active species may be generated by plasma-discharging the discharge gas introduced the plasma generator 110. The plasma gas including the active species generated by the plasma generator 110 may be discharged toward the substrate 132 through the nozzle unit 112.

The carrier gas may be introduced into the nozzle unit by the suspension providing device 120, at S430. Referring to FIGS. 1 to 3B, the suspension providing devices 120 and 320 may use the carrier gas flowing along the passage part 324 connected to the nozzle units 112 and 312 to inject the suspension contained in the containing part 326 into the dispenser 322.

The dispenser 322 may eject the suspension as a gas or spray type to one side of the nozzle units 112 and 312, at S440.

The suspension may be ejected from the nozzle unit toward the substrate so that the substrate may be coated, at S450. Referring to FIG. 1, coating and depositing on the substrate 132 of the nanoparticles ionized by plasma gas can be easily performed.

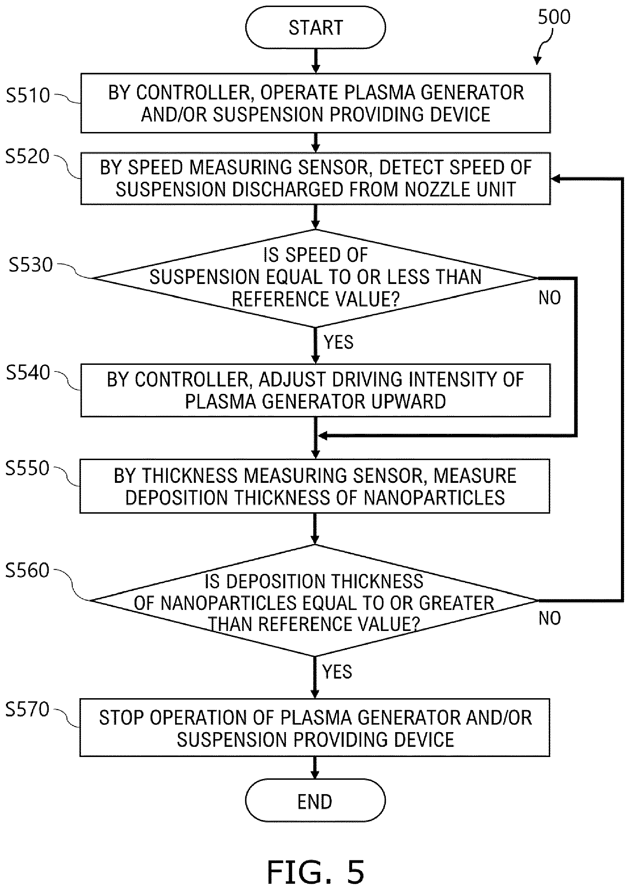

FIG. 5 is a flowchart illustrating a suspension coating method 500 using the atmospheric pressure plasma generator according to another example.

The suspension coating method 500 may be initiated by the controller operating the plasma generator and/or the suspension providing device, at S510. Referring to FIG. 2, the controller 210 may operate the plasma generator 110 and the suspension providing device 120 such that the suspension is discharged to the substrate 132.

The speed measuring sensor may detect the speed of the suspension discharged from the nozzle unit, at S520. Referring to FIG. 2, the speed measuring sensor 220 may measure the speed of the suspension discharged from the nozzle unit 112 toward the substrate 132. In addition, the speed measuring sensor 220 may transmit an electrical signal determined according to the moving speed of the suspension to the controller 210.

The controller may determine whether or not the measured moving speed of the suspension is equal to or less than a reference value, at S530. Referring to FIG. 2, the controller 210 may determine whether or not the moving speed of the suspension is equal to or less than the reference value, based on the electrical signal of the speed measuring sensor 220.

If it is determined that the speed measured in step S530 is equal to or less than the reference value, the controller may adjust to increase the driving intensity of the plasma generator, at S540. Referring to FIG. 2, if the controller 210 determines that the moving speed of the suspension is equal to or less than the reference value based on the electrical signal of the speed measuring sensor 220, the controller 210 may adjust the driving intensity of the plasma generator 110 upward. As described above, as the driving intensity of the plasma generator 110 is adjusted upward, the moving speed of the suspension can be increased, and thus the nanoparticle coating loss rate of the substrate 132 can be reduced.

The thickness measuring sensor 230 may measure the thickness of the nanoparticles deposited on the substrate, at S550. Referring to FIG. 2, the thickness measuring sensor 230 may transmit an electrical signal determined according to the thickness of the nanoparticles deposited on the substrate 132 to the controller 210.

The controller may determine whether or not the deposition thickness of the nanoparticles is equal to or greater than a reference value, at S560. Referring to FIG. 2, the controller 210 may determine whether or not the thickness of the nanoparticles deposited on the substrate 132 is equal to or greater than the reference value based on the electrical signal of the thickness measuring sensor 230.

If it is determined that the deposition thickness of the nanoparticles measured at step S560 is equal to or greater than the reference value, the controller may stop the operation of the plasma generator and/or the suspension providing device, at S570. Referring to FIG. 2, if it is determined that the deposition thickness of the nanoparticles deposited on the substrate 132 is equal to or greater than the reference value based on the electrical signal of the thickness measuring sensor 230, the controller 210 may stop the operation of the plasma generator 110 and/or the suspension providing device 120. Accordingly, deposition coating of nanoparticles on the substrate 132 may be completed.

The operations of the controller or the control unit described above may be provided as a computer program stored in a computer-readable recording medium for execution on a computer. The medium may be a type of medium that continuously stores a program executable by a computer, or temporarily stores the program for execution or download. In addition, the medium may be a variety of recording means or storage means having a single piece of hardware or a combination of several pieces of hardware, and is not limited to a medium that is directly connected to any computer system, and accordingly, may be present on a network in a distributed manner. An example of the medium includes a medium configured to store program instructions, including a magnetic medium such as a hard disk, a floppy disk, and a magnetic tape, an optical medium such as a CD-ROM and a DVD, a magnetic-optical medium such as a floptical disk, and a ROM, a RAM, a flash memory, and so on. In addition, other examples of the medium may include an app store that distributes applications, a site that supplies or distributes various software, and a recording medium or a storage medium managed by a server.

The operation, method, or techniques of the controller or the control unit of the present disclosure may be implemented by various means. For example, these techniques may be implemented in hardware, firmware, software, or a combination thereof. Those skilled in the art will further appreciate that various illustrative logical blocks, modules, circuits, and algorithm steps described in connection with the disclosure herein may be implemented in electronic hardware, computer software, or combinations of both. To clearly illustrate this interchangeability of hardware and software, various illustrative components, blocks, modules, circuits, and steps have been described above generally in terms of their functionality. Whether such a function is implemented as hardware or software varies according to design requirements imposed on the particular application and the overall system. Those skilled in the art may implement the described functions in varying ways for each particular application, but such implementation should not be interpreted as causing a departure from the scope of the present disclosure.

In a hardware implementation, processing units used to perform the techniques may be implemented in one or more ASICs, DSPs, digital signal processing devices (DSPDs), programmable logic devices (PLDs), field programmable gate arrays (FPGAs), processors, controllers, microcontrollers, microprocessors, electronic devices, other electronic units designed to perform the functions described in the present disclosure, computer, or a combination thereof.

Accordingly, the controller or the control unit of the present disclosure may be implemented by various illustrative logical blocks, modules, and circuits. For example, the controller or the control unit may be implemented or performed with general purpose processors, DSPs, ASICs, FPGAs or other programmable logic devices, discrete gate or transistor logic, discrete hardware components, or any combination of those designed to perform the functions described herein. The general purpose processor may be a microprocessor, but in the alternative, the processor may be any related processor, controller, microcontroller, or state machine. The processor may also be implemented as a combination of computing devices, for example, a DSP and microprocessor, a plurality of microprocessors, one or more microprocessors associated with a DSP core, or any other combination of the configurations.

In the implementation using firmware and/or software, the techniques may be implemented with instructions stored on a computer-readable medium, such as random access memory (RAM), read-only memory (ROM), non-volatile random access memory (NVRAM), programmable read-only memory (PROM), erasable programmable read-only memory (EPROM), electrically erasable PROM (EEPROM), flash memory, compact disc (CD), magnetic or optical data storage devices, and the like. The instructions may be executable by one or more processors, and may cause the processor(s) to perform certain aspects of the functions described in the present disclosure.

Although the examples described above have been described as utilizing aspects of the currently disclosed subject matter in one or more standalone computer devices or systems, the present disclosure is not limited thereto, and may be implemented in conjunction with any computing environment, such as a network or distributed computing environment. Furthermore, the aspects of the subject matter in the present disclosure may be implemented in multiple processing chips or devices, and storage may be similarly influenced across a plurality of devices. Such devices may include PCs, network servers, and portable devices.

Although the present disclosure has been described in connection with some examples herein, various modifications and changes can be made without departing from the scope of the present disclosure, which can be understood by those skilled in the art to which the present disclosure pertains. In addition, such modifications and changes should be considered within the scope of the claims appended herein.

## Claims

1. A suspension coating system (100) using an atmospheric pressure plasma generator (110), comprising:
a support (130) that fixedly supports a substrate (132);
a plasma generator (110) that generates active species through plasma discharge, and includes a nozzle unit (112) of which at least a portion is disposed to face the substrate (132); and
a suspension providing device (120) that transfers a suspension including nanoparticles (328) and a binder to one side of the nozzle unit (112).

2. The suspension coating system (100) according to claim 1, wherein the suspension comprises nanoparticles (328) and a binder, and
in the nozzle unit (112), the nanoparticles (328) are ionized and deposited by a plasma gas including the active species, and the binder is vaporized.

3. The suspension coating system (100) according to claim 1, wherein the nanoparticles (328) include nanoparticles (328) used in a spray deposition coating.

4. The suspension coating system (100) according to claim 1, wherein the suspension providing device (320) includes:
a dispenser (322) connected at one side to the nozzle unit (312) and ejecting the suspension to one side of the nozzle unit (312);
a passage part (324) connected at one side to the dispenser (322) and configured to move the suspension injected from the other side to the dispenser (322); and
a containing part (326) connected at one side to the passage part (324), wherein the containing part (326) contains therein the suspension, and provides the suspension to the passage part (324) using a carrier gas injected from the other side.

5. The suspension coating system (100) according to claim 1, wherein the support (130) is configured to fixedly support the substrate (132) at one end, and adjust a distance between the nozzle unit (112) and the substrate (132).

6. The suspension coating system (200) according to claim 1, further comprising:
a speed measuring sensor (220) configured to measure an ejection speed of the suspension; and
a controller (210) that controls a driving intensity of the plasma generator (110) based on the ejection speed measured by the speed measuring sensor (220).

7. The suspension coating system (200) according to claim 1, further comprising:
a thickness measuring sensor (230) configured to measure a thickness of the nanoparticles (328) deposited on the substrate (132); and
a controller (210) that controls whether or not to drive the plasma generator (110) and the suspension providing device (120), based on a deposition thickness of the nanoparticles (328) measured by the thickness measuring sensor (230).

8. A suspension coating method using an atmospheric pressure plasma generator (310), comprising:
by a plasma generator (310) including a nozzle unit (312), plasma-discharging a discharge gas to generate active species;
by a suspension providing device (320), ejecting a suspension to one side of the nozzle unit (312);
at the nozzle unit (312), ionizing nanoparticles (328) by the active species and vaporizing a binder (327); and
depositing and coating the ionized nanoparticles (328) on a substrate (132).

9. The suspension coating method according to claim 8, further comprising adjusting a distance between the nozzle unit (312) and the substrate (132) by a support (130) that fixedly supports the substrate (132) from one side.

10. The suspension coating method according to claim 8, further comprising:
by a speed measuring sensor (220), measuring an ejection speed of the suspension in the suspension providing device (320);
by a thickness measuring sensor (230), measuring a deposition thickness of the nanoparticles (328) deposited on the substrate (132);
by a controller (210), controlling a driving intensity of the plasma generator (310) based on the ejection speed measured by the speed measuring sensor (220); and
by the controller (210), controlling whether or not to drive the plasma generator (310) and the suspension providing device (320), based on the deposition thickness of the nanoparticles (328) measured by the thickness measuring sensor (230).
